# FASCICULE DE BREVET EUROPEEN

(11) **EP 2 812 715 B1**
(45) Date de publication et mention de la délivrance du brevet: **19.08.2020**
(21) Numéro de dépôt: 13702655.5
(22) Date de dépôt: 07.02.2013
(51) Int. Cl.: G01R 33/31, G01R 33/38, G01R 33/30

(54) **DISPOSITIF D'ISOLATION THERMIQUE POUR SONDE D'ANALYSE PAR RMN**
WÄRMEDÄMMUNGSVORRICHTUNG FÜR NMR-SONDE
THERMAL INSULATION DEVICE FOR NMR PROBE

(30) Priorité: 07.02.2012 FR 1251115
(43) Date de publication de la demande: 17.12.2014
(73) Titulaire: Commissariat à l'Énergie Atomique et aux Énergies Alternatives, 75015 Paris (FR)
(72) Inventeur: DE PAËPE, Gaël, F-38500 Voiron (FR); BOULEAU, Eric, F-38360 Sassenage (FR)
(74) Mandataire: Novaimo
(86) Numéro de dépôt international: PCT/EP2013/052398
(87) Numéro de publication internationale: WO 2013/117627

(56) Documents cités:
- FR-A1- 2 008 564
- FR-A1- 2 393 304
- FR-A1- 2 547 125
- US-A- 4 511 841
- US-A- 4 587 492
- US-A- 4 926 647
- US-A- 5 508 613
- US-A1- 2006 130 493
- MIZUNO TAKASHI ET AL: "Development of a magic-angle spinning nuclear magnetic resonance probe with a cryogenic detection system for sensitivity enhancement", REVIEW OF SCIENTIFIC INSTRUMENTS, AIP, MELVILLE, NY, US, vol. 79, no. 4, 28 avril 2008 (2008-04-28) , pages 44706-44706, XP012115347, ISSN: 0034-6748, DOI: 10.1063/1.2912946
- BARNES A B ET AL: "Cryogenic sample exchange NMR probe for magic angle spinning dynamic nuclear polarization", JOURNAL OF MAGNETIC RESONANCE, ACADEMIC PRESS, ORLANDO, FL, US, vol. 198, no. 2, 1 June 2009 (2009-06-01), pages 261-270, XP026101448, ISSN: 1090-7807, DOI: 10.1016/J.JMR.2009.03.003 [retrieved on 2009-03-17]

## Description

L'invention concerne un procédé d'isolation thermique ou un procédé de fonctionnement d'un dispositif d'isolation thermique. L'invention concerne aussi un dispositif d'isolation thermique, notamment un dispositif d'isolation thermique de tout ou partie d'un système à résonance magnétique nucléaire (RMN), particulièrement un système adapté pour l'analyse d'un échantillon de matière.

Un dispositif à RMN comprend une sonde comprenant un porte-échantillon mis en rotation dans un champ magnétique statique et exposé à un second champ magnétique perpendiculaire au premier, par exemple créé par une bobine radiofréquence, qui reçoit en retour un signal qui est analysé pour en déduire des informations sur un échantillon, notamment un échantillon solide, disposé dans le porte-échantillon. Selon une réalisation de l'état de la technique, trois flux gazeux provenant d'une même source, un container standard comme une bouteille d'hélium montée en pression, sont dirigés vers la sonde du dispositif qui comprend le porte-échantillon. Le premier flux a pour fonction de mettre en rotation ce porte-échantillon, en agissant sur les pales ou ailettes d'une turbine d'entraînement d'un rotor (ou module de rotation) qui comprend le porte-échantillon. Le second flux a pour fonction de porter l'échantillon à une certaine température, et le troisième flux crée un palier aérostatique de sustentation du rotor dans le stator.

Dans un tel dispositif, il est important d'éliminer le risque de condensation des gaz atmosphériques sur la sonde dans le cas d'un fonctionnement à basse température et de définir une architecture de sonde qui garantisse l'obtention de la température ad hoc au niveau du porte-échantillon.

Pour cela, plusieurs conditions doivent être respectées :
- La sonde doit être isolée de l'atmosphère environnante pour la protéger de la condensation et de la convection gazeuse pour supprimer les apports extérieurs de chaleur convectifs et dus à la conduction gazeuse.
- La sonde, le module de rotation et son dispositif d'alimentation fluidique doivent être protégés du rayonnement thermique environnant à une température d'environ 300K.

La sonde, et plus globalement le dispositif à RMN fonctionnant à très basse température, il est nécessaire de les calorifuger pour atteindre les températures souhaitées et/ou pour ne pas consommer trop d'énergie pour les refroidir.

Pour calorifuger ou isoler un dispositif refroidi, on connaît diverses techniques, notamment :
- l'enfouissement dans des matériaux isolants permettant d'éviter les déperditions par convection, voire par conduction, ou
- la mise en place d'écrans anti-rayonnement permettant d'éviter les déperditions par rayonnement.

La température d'un écran anti-rayonnement est influencée par les pièces «chaudes» et les pièces «froides» qui sont en regard de l'écran. Cette influence varie selon la puissance 4 de l'écart de température entre les pièces chaudes et les pièces froides, la température de l'écran étant principalement influencée par les pièces «chaudes», en particulier dans le cas d'un fonctionnement à très basse température.

Le but de l'invention est de fournir un procédé de fonctionnement d'un dispositif d'isolation permettant de remédier aux problèmes évoqués précédemment et améliorant les procédés connus de l'art antérieur. En particulier, l'invention propose un système d'analyse par RMN avec rotation à l'angle magique ou selon l'angle magique comprenant une sonde d'analyse par RMN et un dispositif d'isolation permettant d'assurer une isolation efficace et/ou consommant peu d'énergie tel que défini dans la revendication indépendante 1. objets, caractéristiques et avantages de la présente invention seront exposés en détail dans la description suivante d'un mode de réalisation particulier fait à titre non-limitatif en relation avec les figures jointes parmi lesquelles :
La figure 1 représente schématiquement un système à RMN selon un mode de réalisation de l'invention.
La figure 2 représente schématiquement une sonde RMN selon un mode de réalisation de l'invention.

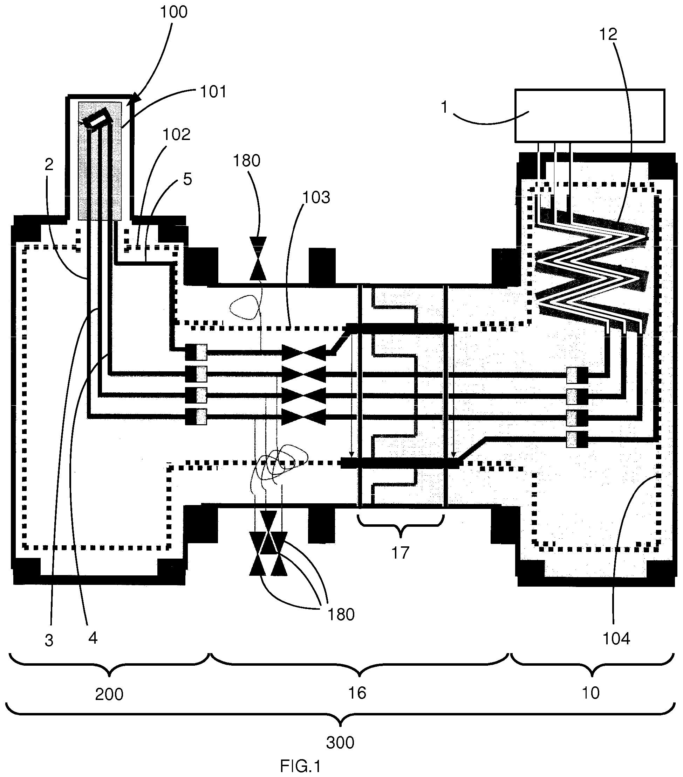

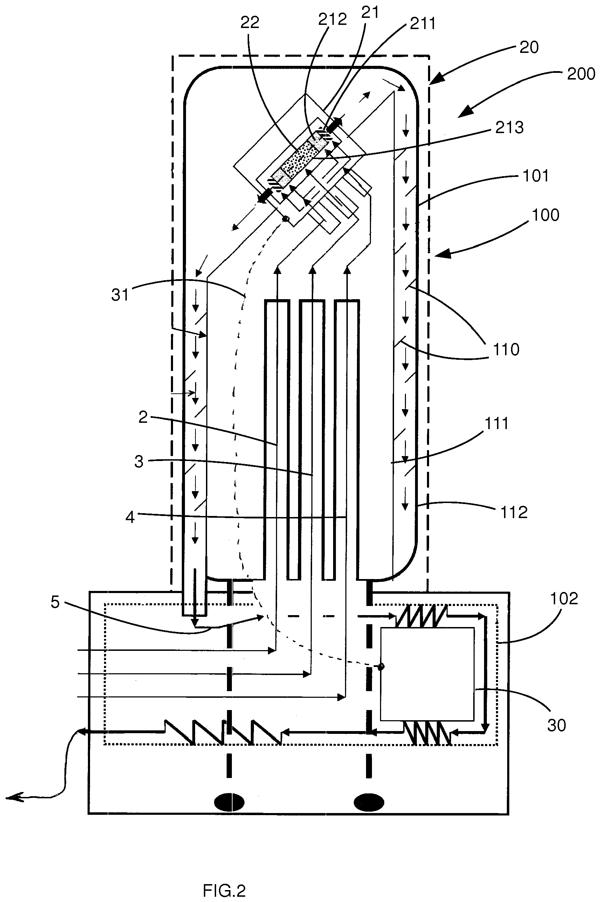

Un mode de réalisation d'un dispositif 100 d'isolation est décrit ci-après, en référence aux figures 1 et 2, appliqué à un système d'analyse RMN 300.

Le système d'analyse RMN 300 comprend le dispositif 100 d'isolation. Il s'agit d'un système d'analyse RMN avec rotation à l'angle magique ou selon l'angle magique. Par exemple, le système d'analyse comprend au moins une première source 1 haute pression permettant de générer trois flux gazeux 2, 3, 4 haute pression. En variante, on peut bien sûr utiliser plusieurs sources dédiées chacune à un ou plusieurs flux. Cette source 1 peut par exemple consister en une bouteille de gaz comprimé à 200 bars et à température ambiante. La pression peut être contrôlée par des débitmètres couplés à des vannes de régulation. Le gaz haute pression de cette première source 1 peut être de l'azote ou de l'hélium. Les trois flux gazeux provenant de cette première source 1 traversent un cryostat 10, dans lequel ils sont refroidis dans un ou plusieurs échangeurs de chaleur 12, avant d'atteindre une sonde RMN 20 comprenant un porte-échantillon 21 destiné à recevoir un échantillon 22. Le porte échantillon est positionné de manière inclinée avec un angle ajustable compris entre les axes parallèle et perpendiculaire d'un champ magnétique statique. Des composants radiofréquences formant un émetteur/récepteur, prévus pour recevoir en retour un signal provenant de l'échantillon à analyser, sont aussi exposés au flux gazeux de refroidissement et soumis à la même température que le porte-échantillon 21. Pour pouvoir atteindre des températures très basses, les échangeurs de chaleur 12 sont alimentés par un fluide cryogénique basse pression, à basse température inférieure à la température du gaz de la première source 1, qui sert de fluide réfrigérant, provenant d'une ou plusieurs seconde(s) source(s), distincte(s) de la première source 1 haute pression. Ce fluide réfrigérant peut aussi être de l'azote ou de l'hélium.

L'échangeur de chaleur peut être de type fluide/fluide tubulaire à contre courant. Il permet un transfert de chaleur entre les deux fluides, induisant un refroidissement des flux gazeux 2, 3, 4 haute pression. Cet échange thermique entre les deux fluides est obtenu par une convection forcée entre les flux gazeux 2, 3, 4 et la paroi de leurs tubes haute pression respectifs, puis par conduction à travers cette paroi, avant une nouvelle convection forcée entre la surface extérieure de cette paroi des tubes haute pression et le fluide réfrigérant. Ces tubes peuvent être formés dans un matériau adapté à la cryogénie, par exemple en nuance d'acier inoxydable austénitique dit à bas carbone.

Le cryostat 10 se présente globalement sous la forme d'une enceinte à vide fermée par une platine amovible qui permet l'accès à sa partie interne. Le cryostat peut avantageusement comprendre un écran thermique 104.

Ensuite, en sortie du cryostat 10, les trois flux gazeux 2, 3, 4 atteignent la sonde RMN 20, refroidis avantageusement à la même température, et remplissent les trois fonctions mentionnées précédemment, c'est-à-dire que le premier flux 2 haute pression met en rotation l'échantillon, le second flux 3 haute pression refroidit l'échantillon et le troisième flux 4 haute pression permet la mise en sustentation du porte-échantillon.

Une ligne cryogénique 16 rigide permet de conduire les flux gazeux 2, 3, 4 haute pression refroidis depuis la sortie du cryostat 10 jusqu'au dispositif de sonde RMN 20. Cette ligne est courte, de longueur de l'ordre d'un mètre, isolée, pompée en vide secondaire et équipée d'un écran thermique 103. La sonde RMN 20 comprend un porte-échantillon 21 mobile en rotation, placé dans un stator (non représenté) établissant le champ magnétique statique de la mesure RMN.

Le système comprend des composants électroniques 30, notamment des composants radiofréquences, par exemple au niveau du dispositif de sonde 200. Une liaison 31 permet de coupler un circuit électrique 30 au module de rotation.

Le dispositif 100 d'isolation thermique comprend un écran 101, 102, 103, 104 d'isolation thermique d'un premier organe 21 et/ou d'un deuxième organe 20 ; 30 ; 16 ; 10 ; 40 vis-à-vis d'un rayonnement thermique. Le rayonnement thermique peut être dû à tout élément de l'environnement du premier organe ou du deuxième organe, notamment tout corps se trouvant dans cet environnement. Le dispositif d'isolation comprend :
- un premier élément 110 d'échange thermique entre l'écran thermique et le flux de fluide, notamment le flux de gaz, et
- un élément 211 de guidage du premier organe utilisant le flux et/ou un élément 212 d'entraînement du premier organe utilisant le flux et/ou un deuxième élément 213 d'échange thermique du premier organe utilisant le flux.

L'élément 211 de guidage est alimenté par le flux gazeux 4, l'élément 212 d'entraînement est alimenté par le flux gazeux 2 et l'élément 213 d'échange thermique du premier organe est alimenté par le flux gazeux 3. L'élément de guidage peut être un palier, notamment un palier aérostatique ou un palier aérodynamique. Ainsi, on peut utiliser un flux pour guider le premier organe. L'élément d'entraînement peut être une turbine. Ainsi, on peut utiliser un flux pour entraîner en mouvement le premier organe.

Le premier élément 110 d'échange thermique permet de refroidir l'écran ou les écrans. Ainsi, la température de l'écran ou des écrans est peu influencée par l'environnement extérieur à l'écran. Le ou les écrans sont de préférence réalisés en métal, pour qu'ils présentent une conductivité thermique élevée et/ou une faible capacité à absorber le rayonnement thermique.

De préférence, le premier organe comprend le porte-échantillon et/ou le deuxième organe comprend la sonde à RMN 20 et/ou la ligne cryogénique 16 et/ou le cryostat 10 et/ou le circuit électronique 30. Ainsi, le dispositif peut comprendre un premier écran d'isolation thermique 101, 102 protégeant le porte-échantillon 21 et l'échantillon de matière 22 et plus généralement la sonde 20 et éventuellement le circuit électronique. Le dispositif d'isolation peut aussi comprendre un deuxième écran d'isolation thermique 103 protégeant la ligne cryogénique 16 et/ou le dispositif d'isolation peut comprendre un troisième écran d'isolation thermique 104 protégeant le cryostat 10. Les différents écrans peuvent être couplés thermiquement les uns aux autres.

Le premier élément d'échange 110 est compris entre deux parois 111 et 112 de l'écran d'isolation thermique. Il peut être constitué d'un ruban hélicoïdal 110.

Un, deux ou trois des flux de fluides 2, 3, 4 parcourent le premier élément d'échange après avoir assuré leur fonction au niveau de la sonde, notamment au niveau du porte-échantillon. Pour ce faire, le dispositif d'isolation comprend un élément de guidage du flux de fluide entre :
- le premier élément 110 d'échange thermique, et
- l'élément 211 de guidage du premier organe utilisant le flux et/ou l'élément 212 d'entraînement du premier organe utilisant le flux et/ou le deuxième élément 213 d'échange thermique du premier organe utilisant le flux.

Compte tenu du flux important nécessaire à la mise en rotation du porte-échantillon, le fluide cryogénique utilisé ne cède qu'une partie de son énergie thermique (enthalpie) pour porter à la température ad hoc l'échantillon. Aussi, le flux expulsé en sortie du module de rotation du porte-échantillon est collecté afin de récupérer et de disposer avantageusement de l'énergie thermique encore disponible. Pour cela, les flux de gaz « moteur » et « thermorégulateur » évacués à l'échappement du module de rotation sont directement recueillis dans l'enceinte où il est installé. Le module est ainsi maintenu dans une atmosphère gazeuse à basse température qui le protège efficacement du rayonnement extérieur. L'enceinte est elle-même équipée d'une sortie par laquelle s'évacue ce gaz qui va transiter via une ligne 5 dans des échangeurs en couplage thermique avec des écrans d'isolation ou de protection thermique actifs, notamment un échangeur en couplage thermique avec l'écran 102 de protection de la sonde, un échangeur en couplage thermique avec l'écran 103 thermique actif de protection de la ligne cryogénique d'alimentation et éventuellement un échangeur en couplage thermique avec l'écran 104 thermique actif de protection du cryostat, source de la puissance cryogénique. Le gaz peut aussi transiter dans un échangeur en couplage thermique avec le circuit électronique 30. La forme de l'enceinte 101, annulaire dans sa partie inférieure, est telle qu'elle joue le rôle d'écran thermique très basse température pour les lignes d'injection de fluide. Pour tirer profit de façon optimale de l'énergie contenue dans le gaz évacué, celui-ci, avant d'être rejeté hors de l'enceinte, peut être guidé suivant une trajectoire hélicoïdale dans une double enveloppe comme vu précédemment. Cette disposition offre une plus grande surface d'échange entre le gaz froid et la paroi de l'enceinte.

Les composants de la sonde potentiellement portés à basses températures sont supportés ou suspendus mécaniquement par des pièces réalisées dans un matériau thermiquement isolant. Dans le même esprit, chacune des lignes d'alimentation du fluide est réalisée en deux tronçons pour ne pas transmettre de chaleur au module de rotation. La partie amont qui traverse une enveloppe d'enceinte de confinement pour introduire du fluide dans le module de rotation comprenant le porte-échantillon, ou en extraire, est réalisée dans un matériau métallique faiblement conducteur. Cette zone est appelée zone à gradient thermique. Bien que dans l'art antérieur on utilise des tuyaux en acier inoxydable, on peut utiliser dans le cadre de l'invention des tuyaux en cuivre.

L'ensemble est inséré dans une enceinte à vide munie de traversées « étanches au vide » par lesquelles transitent les servitudes utiles au fonctionnement de la sonde (fluides, signaux d'instrumentation, puissance, réglages mécaniques, etc..).

Le premier élément d'échange 110 est couplé thermiquement à l'écran d'isolation thermique, notamment est fixé à l'écran d'isolation thermique.

L'écran thermique présente un angle solide d'au moins π stéradians, voire d'au moins 2π stéradians, voire d'au moins 3π stéradians, voire de sensiblement 4π stéradians vu du centre de gravité du premier organe et/ou du deuxième organe, voire de tout point du premier organe et/ou du deuxième organe.

L'invention porte aussi sur le système 200 de sonde d'analyse par RMN, le système comprenant le dispositif d'isolation thermique 100 et la sonde 20 d'analyse par RMN.

La ligne cryogénique d'alimentation de la sonde par le cryostat est à très basse consommation. Comme évoqué avant, elle est équipée d'un écran thermique 103 actif en couplage thermique avec le flux sortant de la sonde. Les pertes de cette ligne, longue d'un mètre, super isolée par un isolant multi-couches et pompée en vide secondaire sont de l'ordre de 0,11W sur l'ensemble des 3 lignes d'alimentation de la sonde. Ces pertes sont 10 fois moindres que dans les lignes souples communément utilisées pour alimenter à basse température des sondes RMN. En effet, la consommation de ces lignes est de 30W/m voire 5W/m pour les meilleures lignes sous vide statique et isolées par des mousses ou des poudres allant pour une ligne de haute qualité, super isolée et sous vide dynamique, jusqu'à 1W/m.

Selon l'invention, la ligne cryogénique 16 comprend une barrière à vide 17. Ainsi, la ligne est scindée en deux zones indépendantes par une « barrière à vide » et par un jeu de vannes 180 montées sur les lignes « haute pression » et « basse pression », de telle sorte que la sonde peut être déconnectée du cryostat sans devoir arrêter le fonctionnement de ce dernier. On peut utiliser ces vannes pour faire circuler un fluide à une température adéquate pour permettre de faire varier la température de la sonde, notamment de faire remonter la température de la sonde.

Le système de sonde 200 comprend la sonde 20 et un stator. La sonde et ses lignes d'alimentation en fluide sont encapsulées hermétiquement avec une enceinte sous vide, un écran anti-rayonnement et un support isolant. Le système comprend encore une unité centrale, non représentée, qui comprend des éléments matériel (hardware) et logiciel (software) de mise en œuvre d'un procédé de fonctionnement du dispositif d'isolation et, plus généralement, de mise en œuvre d'un procédé de fonctionnement du système d'analyse.

Un mode d'exécution du procédé de fonctionnement du dispositif 100 d'isolation thermique comprenant l'écran d'isolation du premier organe et/ou du deuxième organe vis-à-vis d'un rayonnement thermique est décrit ci-après. Le procédé comprend :
- une étape d'échange thermique entre le flux du fluide, notamment du gaz, et l'écran, notamment une étape de transfert de chaleur de l'écran thermique au flux, et
- une étape d'utilisation du flux pour guider le premier organe, et/ou pour entraîner en mouvement le premier organe, et/ou pour échanger de la chaleur avec le premier organe, notamment pour refroidir le premier organe.

Dans l'étape d'échange thermique, le flux de fluide permet par exemple de refroidir l'écran.

Dans l'étape d'utilisation du flux pour échanger de la chaleur avec le premier organe, le flux de fluide permet par exemple de refroidir le premier organe.

De préférence, on met en œuvre d'abord l'étape d'utilisation, puis l'étape d'échange thermique.

De préférence, le premier organe comprend le porte-échantillon et/ou le deuxième organe comprend la sonde à RMN 20 et/ou la ligne cryogénique 16 et/ou le cryostat 10 et/ou le circuit électronique 40.

Un tel dispositif d'isolation permet de limiter les besoins en réchauffement des gaz après leur utilisation au niveau de la sonde, le réchauffement permettant d'assurer la sécurité du personnel, d'éviter leur brûlure au contact de pièces très froides et d'éviter des chutes par glissade suite à la fonte des condensats, ou leur électrisation. Le réchauffement permet aussi de réduire les risques de dégradation du matériel par des courts-circuits ou par oxydation de pièces métalliques. Enfin, au moins les fluides les plus coûteux, comme l'hélium, peuvent être récupérés par un dispositif de récupération, pour être réutilisés. Ils peuvent aussi être directement injectés dans l'échangeur à contre-courant 12 via une machine frigorifique afin de réaliser un système en boucle fermée ; la circulation est alors assurée par un compresseur « chaud » à l'extérieur du cryostat ou « froid » à l'intérieur du cryostat.

## Revendications

1. Système (300) d'analyse par RMN avec rotation à l'angle magique ou selon l'angle magique comprenant un système de sonde (200) comprenant lui-même une sonde d'analyse par RMN (20) et un dispositif (100) d'isolation thermique, ledit système d'isolation thermique (100) comprenant un écran (101 ; 102 ; 103 ; 104) d'isolation d'un premier organe (21) et/ou d'un deuxième organe (20 ; 30 ; 16 ; 10 ; 30) vis-à-vis d'un rayonnement thermique, le dispositif comprenant :
- un premier élément (110) d'échange thermique entre l'écran thermique et un flux de fluide, notamment un flux de gaz, et
- un élément (211) de guidage du premier organe utilisant le flux et/ou un élément (212) d'entraînement du premier organe utilisant le flux et/ou un deuxième élément (213) d'échange thermique du premier organe utilisant le flux, le système d'analyse comprenant un cryostat (10) et une ligne cryogénique (16) reliant la sonde et le cryostat,
**caractérisé en ce que** la ligne cryogénique (16) comprend une barrière à vide (17) et un jeu de vannes (180), de telle sorte que la sonde d'analyse par RMN (20) peut être déconnectée du cryostat (10) sans devoir arrêter le fonctionnement dudit cryostat (10).

2. Système selon la revendication précédente, **caractérisé en ce que** le premier élément d'échange est couplé thermiquement à l'écran d'isolation thermique, notamment est fixé à l'écran d'isolation thermique, ou **en ce que** le premier élément d'échange est compris entre deux parois (111, 112) de l'écran d'isolation thermique.

3. Système selon l'une des revendications 1 et 2, **caractérisé en ce que** le premier élément d'échange est un ruban hélicoïdal (110).

4. Système selon l'une des revendications 1 à 3, **caractérisé en ce que** l'écran thermique présente un angle solide d'au moins π stéradians, voire d'au moins 2π stéradians, voire d'au moins 3π stéradians, voire de sensiblement 4π stéradians vu du centre de gravité du premier organe et/ou du deuxième organe, voire de tout point du premier organe et/ou du deuxième organe.

5. Système selon l'une des revendications 1 à 4, **caractérisé en ce qu'**il comprend un élément de guidage du flux de fluide entre :
- le premier élément (110) d'échange thermique, et
- l'élément (211) de guidage du premier organe utilisant le flux et/ou l'élément (212) d'entraînement du premier organe utilisant le flux et/ou le deuxième élément (213) d'échange thermique du premier organe utilisant le flux.

6. Système d'analyse selon l'une des revendications 1 à 5, **caractérisé en ce qu'**il comprend un porte-échantillon (21), apte à recevoir un échantillon (22) à analyser, et au moins une première source (1) d'un gaz haute pression pour générer le flux.

## Patentansprüche

1. NMR-Analysesystem (300) mit Drehung im magischen Winkel oder gemäß dem magischen Winkel umfassend ein Sondensystem (200) selbst umfassend eine NMR-Analysesonde (20) und eine Wärmeisolationsvorrichtung (100), das Wärmeisolationssystem (100) umfassend einen Schirm (101; 102; 103; 104) zur Isolierung eines ersten Organs (21) und/oder eines zweiten Organs (20; 30; 16; 10; 30) gegenüber einer Wärmestrahlung, die Vorrichtung umfassend:
- ein erstes Element (110) zum Wärmeaustausch zwischen dem Wärmeschirm und einem Fluidstrom, insbesondere einem Gasstrom, und
- ein Leitelement (211) des ersten Organs, das den Strom nutzt, und/oder ein Antriebssystem (212) des ersten Organs, das den Strom nutzt, und/oder ein zweites Wärmeaustauschelement (213) des ersten Organs, das den Strom nutzt, das Analysesystem umfassend einen Kryostat (10) und eine Kryogenleitung (16), die die Sonde und den Kryostat verbindet,
**dadurch gekennzeichnet, dass** die Kryogenleitung (16) eine Vakuumsperre (17) und einen Ventilsatz (180) umfasst, so dass die NMR-Analysesonde (20) von dem Kryostat (10) getrennt werden kann, ohne den Betrieb des Kryostats (10) anhalten zu müssen.

2. System nach dem vorhergehenden Anspruch, **dadurch gekennzeichnet, dass** das erste Austauschsystem thermisch mit dem Wärmeisolationsschirm gekoppelt, insbesondere an dem Wärmeisolationsschirm befestigt ist, oder dadurch, dass das erste Austauschelement zwischen zwei Wänden (111, 112) des Wärmeisolationsschirms enthalten ist.

3. System nach einem der Ansprüche 1 und 2, **dadurch gekennzeichnet, dass** das erste Austauschelement ein spiralförmiges Band (110) ist.

4. System nach einem der Ansprüche 1 bis 3, **dadurch gekennzeichnet, dass** der Wärmeschirm einen Raumwinkel von mindestens π Steradianten sogar mindestens 2n Steradianten, sogar mindestens 3n Steradianten, sogar von im Wesentlichen 4n Steradianten vom Schwerpunkt des ersten Organs und/oder des zweiten Organs, sogar von jedem Punkt des ersten Organs und/oder des zweiten Organs aus betrachtet aufweist.

5. System nach einem der Ansprüche 1 bis 4, **dadurch gekennzeichnet, dass** es ein Element zum Leiten des Fluidstroms zwischen folgenden Elementen umfasst:
- dem ersten Wärmeaustauschelement (110) und
- dem Leitelement (211) des ersten Organs, das den Strom nutzt, und/oder dem Antriebssystem (212) des ersten Organs, das den Strom nutzt, und/oder dem zweiten Wärmeaustauschelement (213) des ersten Organs, das den Strom nutzt.

6. Analysesystem nach einem der Ansprüche 1 bis 5, **dadurch gekennzeichnet, dass** es einen Probenträger (21) umfasst, der geeignet ist, eine zu analysierende Probe (22) aufzunehmen, und mindestens eine erste Quelle (1) eines Hochdruckgases, um den Strom zu erzeugen.

## Claims

1. Magic-angle spinning NMR analysis system (300) comprising a probe system (200), itself comprising a NMR analysis probe (20) and a thermal insulation device (100), said thermal insulation device (100) comprising a screen (101; 102; 103; 104) insulating a first member (21) and/or a second member (20; 30; 16; 10; 30) from a thermal radiation, the device comprising:
- a first heat-exchange element (110) exchanging heat between the heat screen and a stream of fluid, notably a stream of gas, and
- a guide element (211) guiding the first member using the stream and/or a drive element (212) driving the first member using the stream and/or a second heat-exchange element (213) of the first member using the stream,
the analysis system comprising a cryostat (10) and a cryogenic line (16) connecting the probe onto the cryostat,
**characterized in that** the cryogenic line (16) comprises a vacuum barrier (17) and a set of valves (180), in such a way that the NMR analysis probe (20) can be disconnected from the cryostat (10) without the need to switch off said cryostat (10).

2. System according to Claim 1, **characterized in that** the first exchange element is thermally coupled to the thermal insulation screen, notably is fixed to the thermal insulation screen, or wherein the first exchange element is comprised between two walls (111; 112) of the thermal insulation screen.

3. System according to one of Claims 1 and 2, **characterized in that** the first exchange element is a helical strip.

4. System according to one of Claims 1 to 3, **characterized in that** the heat screen has a solid angle of at least π steradians, or even of at least 2π steradians, or even of at least 3π steradians, or even substantially of 4π steradians as seen from the centre of gravity of the first member and/or of the second member, or even from any point on the first member and/or on the second member.

5. System according to one of Claims 1 to 4, **characterized in that** it comprises a guide element guiding the stream of fluid between:
- the first heat-exchange element (110), and
- the guide element (211) guiding the first member using the stream and/or the drive element (212) driving the first member using the stream and/or the second heat-exchange element (213) of the first member using the stream.

6. Analysis system according to one of Claims 1 to 5, **characterized in that** it comprises a sample holder (21) able to accept a sample (22) for analysis, and at least one first source (1) of a high-pressure gas for generating the stream.
